# EUROPEAN PATENT APPLICATION

(11) **EP 4 407 076 A1**
(43) Date of publication of application: **31.07.2024**
(21) Application number: 23209367.4
(22) Date of filing: 13.11.2023
(51) Int. Cl.: C30B 25/14, C30B 25/16, C23C 16/455

(54) **EPITAXIAL GROWTH APPARATUS AND MULTI-LAYER GAS SUPPLY MODULE USED THEREFOR**

(30) Priority: 05.12.2022 KR 20220167459
(71) Applicant: PJP Tech Inc., Yongin-si, Gyeonggi-do 17096 (KR)
(72) Inventor: Choi, Bum Ho, Goyang-si, Gyeonggi-do 10324 (KR); Park, Kyung Shin, Suwon-si, Gyeonggi-do 16505 (KR); Kwon, Hyun Ho, Hwaseong-si, Gyeonggi-do 18477 (KR); Kim, Dong Hyoun, Incheon 21321 (KR); Lim, Suk Ho, Yongin-si, Gyeonggi-do 17081 (KR); Jeong, Jong Wook, Yongin-si, Gyeonggi-do 17081 (KR); Lee, Seung Soo, Suwon-si, Gyeonggi-do 16699 (KR)
(74) Representative: von Bülow & Tamada

(57) **Abstract**

Provided are an epitaxial growth apparatus and a multi-layer gas supply module used therefor, the epitaxial growth apparatus including: a reaction chamber; a susceptor positioned in the reaction chamber and configured to seat a wafer thereon; and a multi-layer gas supply module configured to supply a gas to the reaction chamber to form an epitaxial layer on the wafer, wherein the multi-layer gas supply module includes an injector including ports of a plurality of layers, each of which discharges a different gas for each layer, among the ports of the plurality of layers, the ports of each layer including a center port corresponding to a central region of the wafer, and a pair of edge ports corresponding to both edge regions of the wafer, and a flow distribution unit configured to distribute gas flows input to the center port and the edge port among the ports of each layer independently from each other.

## Description

### BACKGROUND

### Field

The present disclosure relates to an epitaxial growth apparatus used to grow an epitaxial layer on a wafer, and a gas supply module used therefor.

### Description of the Related Art

In general, epitaxial growth indicates stacking a new layer by using a single crystal growth method while maintaining a lattice direction with respect to a seed wafer. The epitaxial growth may require a growth apparatus allowing a gas to act on the wafer.

A gas supply system of the epitaxial growth apparatus may include an injector, a baffle, an insert, and a liner in an order in which the gas is injected from a gas tank into a chamber.

An important consideration in gas supply is to provide uniform gas distribution in the chamber. Through the uniform gas distribution, an epitaxial layer can have a uniform thickness layer on a large-area substrate (i.e., a substrate having a size of 6 inches or more). The epitaxial layer may achieve a uniformity of 1% or less.

However, in a conventional gas supply system, multiple gases may be injected into the chamber through a single-layer inlet, making it difficult to achieve the uniform gas distribution. This difficulty is especially true for a large-area substrate. In addition, the uniform gas distribution may not be provided to the center and edge of the substrate. As a result, a grown epitaxial layer may have a thickness with a poor uniformity of 5% or more.

### SUMMARY

An object of the present disclosure is to provide an epitaxial growth apparatus which can provide uniform gas distribution in an entire region of a substrate to grow a uniform epitaxial layer on the large-area substrate, and a multi-layer gas supply module used therefor.

According to an embodiment of the present disclosure, an epitaxial growth apparatus includes: a reaction chamber; a susceptor positioned in the reaction chamber and configured to seat a wafer thereon; and a multi-layer gas supply module configured to supply a gas to the reaction chamber to form an epitaxial layer on the wafer, wherein the multi-layer gas supply module includes an injector including ports of a plurality of layers, each of which discharges a different gas for each layer, among the ports of the plurality of layers, the ports of each layer including a center port corresponding to a central region of the wafer, a pair of edge ports corresponding to both edge regions of the wafer, and a pair of middle ports respectively disposed between the center port and the pair of edge ports, a flow distribution unit configured to independently distribute the gas to the ports by including a single inflow line receiving the gas from a source module, a plurality of branch lines branched off from the single inflow line and directly connected to the respective ports, and a mass flow controller connected to each of the ports, and a baffle including through holes which are positioned in front of the injector, and through which the gas discharged from the ports passes, among the through holes, the through holes corresponding to the ports of at least one layer among the ports of the plurality of layers having shapes different from each other.

The center port, the middle port, and the edge port may have the same width as one another.

The ports of the plurality of layers may include ports of a first layer discharging a raw gas forming the epitaxial layer, and ports of a second layer positioned above the ports of the first layer and discharging a blocking gas blocking the raw gas from diffusing upward.

The ports of the plurality of layers may further include ports of the third layer disposed below the ports of the first layer and discharging a purifying gas purifying a by-product occurring during a growth of the epitaxial layer.

The through holes may include the through holes of a first layer corresponding to the ports of the first layer, the through holes of a second layer corresponding to the ports of the second layer, and the through holes of a third layer corresponding to the ports of the third layer, the through holes of the second layer may have a cylindrical shape, and the through holes of the first layer and the through holes of the third layer may have a mixture of the cylindrical shape and a cone shape.

Among the through holes of the first layer and the through holes of the third layer, the through holes corresponding to the center port may have the cylindrical shape, and among the through holes of the first layer and the through holes of the third layer, the through holes corresponding to the edge port may have a cone shape. In addition, the through holes of the third layer may have cross-sectional areas each having a smaller size compared to those of the through holes of the first layer.

According to another embodiment of the present disclosure, provided is a multi-layer gas supply module used for an epitaxial growth apparatus, in which the module supplies a gas input to a reaction chamber of the epitaxial growth apparatus, the module including: an injector including ports of a plurality of layers, each of which discharges a different gas for each layer, among the ports of the plurality of layers, the ports of each layer including a center port corresponding to a central region of the wafer, a pair of edge ports corresponding to both edge regions of the wafer, and a pair of middle ports respectively disposed between the center port and the pair of edge ports; a flow distribution unit configured to independently distribute the gas to the ports by including a single inflow line receiving the gas from a source module configured to provide the gas, a plurality of branch lines branched off from the single inflow line and directly connected to the respective ports, and a mass flow controller connected to each of the ports; and a baffle including through holes which are positioned in front of the injector, and through which the gas discharged from the ports passes, among the through holes, the through holes corresponding to the ports of at least one layer among the ports of the plurality of layers having shapes different from each other.

The center port, the middle port, and the edge port may have the same width as one another.

The ports of the plurality of layers may include ports of a first layer discharging a raw gas forming the epitaxial layer, and ports of a second layer positioned above the ports of the first layer and discharging a blocking gas blocking the raw gas from diffusing upward.

The through holes may include the through holes of a first layer corresponding to the ports of the first layer, the through holes of a second layer corresponding to the ports of the second layer, and the through holes of a third layer corresponding to the ports of the third layer, the through holes of the second layer may have a cylindrical shape, and the through holes of the first layer may have a mixture of the cylindrical shape and a cone shape.

According to still another embodiment of the present disclosure, an epitaxial growth apparatus includes: a reaction chamber; a susceptor positioned in the reaction chamber and configured to seat a wafer thereon; and a multi-layer gas supply module configured to supply a gas to the reaction chamber to form an epitaxial layer on the wafer, wherein the multi-layer gas supply module includes an injector including ports of a plurality of layers, each of which discharges a different gas for each layer, among the ports of the plurality of layers, the ports of each layer including a center port corresponding to a central region of the wafer, and a pair of edge ports corresponding to both edge regions of the wafer, and a flow distribution unit configured to distribute gas flows input to the center port and the edge port among the ports of each layer independently from each other.

Among the ports of the plurality of layers, the ports of each layer may further include a pair of middle ports respectively disposed between the center port and the pair of edge ports, and the flow distribution unit may be configured to distribute the gas flow input to the middle port independently from the gas flow input to the center port or the edge port.

### BRIEF DESCRIPTION OF THE DRAWINGS

FIG. 1 is a conceptual diagram of an epitaxial growth apparatus according to an embodiment of the present disclosure.
FIG. 2 is a perspective view showing a partial configuration of the epitaxial growth apparatus of FIG. 1.
FIG. 3 is a horizontal cross-sectional view showing a configuration related to an injector of FIG. 2.
FIG. 4 is a front view showing the baffle and injector of FIG. 2.
FIG. 5 is a cross-sectional view showing shapes of the center ports and corresponding through holes of FIG. 4.
FIG. 6 is a cross-sectional view showing shapes of the middle ports and corresponding through holes of FIG. 4.
FIG. 7 is a cross-sectional view showing shapes of the edge ports and corresponding through holes of FIG. 4.

### DETAILED DESCRIPTION

Hereinafter, an epitaxial growth apparatus and a multi-layer gas supply module used therefor according to embodiments of the present disclosure are described in detail with reference to the accompanying drawings. Throughout the present disclosure, components that are the same as or similar to each other are denoted by reference numerals that are the same as or similar to each other, and a description thereof is replaced by the first description, even in a different embodiment.

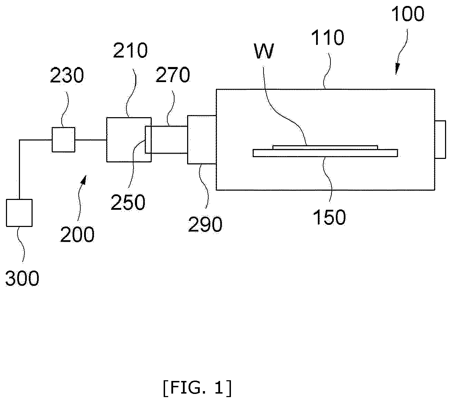

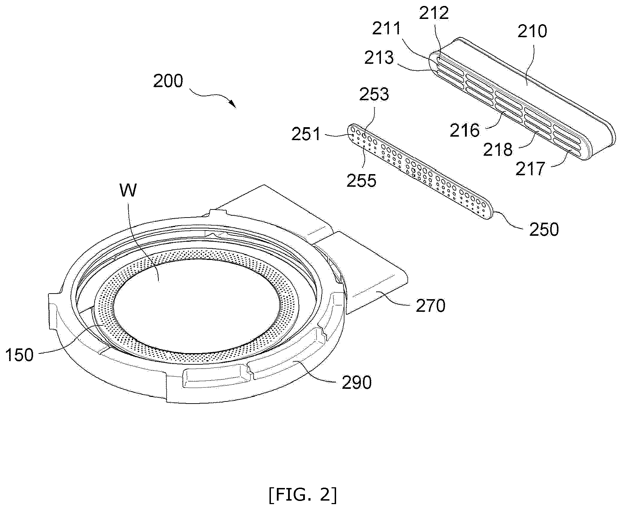

FIG. 1 is a conceptual diagram of an epitaxial growth apparatus according to an embodiment of the present disclosure; and FIG. 2 is a perspective view showing a partial configuration of the epitaxial growth apparatus of FIG. 1.

Referring to these drawings, an epitaxial growth apparatus 100 may include a reaction chamber 110, a susceptor 150, a multi-layer gas supply module 200, and a source module 300.

The reaction chamber 110 may have a reaction space where an epitaxial reaction occurs. The reaction space is simply indicated as a square box in the drawing. However, in detail, the reaction space may be provided by stacking a lower housing (not shown) and an upper housing (not shown). Each of the upper housing and the lower housing may be made of a transparent material such as quartz glass. A gas may be supplied to a left side of the reaction space through the multi-layer gas supply module 200, and discharged to the right side of the reaction space.

The susceptor 150 may be positioned in the reaction space, and may be an object seating a wafer W thereon. The susceptor 150 may have a flat disk shape. The susceptor 150 can be made of carbon graphite or carbon graphite coated with silicon carbide. The wafer W may have a size of 6 inches or 8 inches or more, and thus be classified as having a large area.

The multi-layer gas supply module 200 may provide the gas into the reaction chamber 110 and control a gas flow. The multi-layer gas supply module 200 may include an injector 210, a flow distribution unit 230, a baffle 250, an insert 270, and a liner 290.

The injector 210 may discharge the gas input from the source module 300 toward the reaction chamber 110. The injector 210 may include ports 211, 212, and 213 of a plurality of layers, each outputting a different gas for each layer.

The ports 211 of a first layer can discharge a raw gas forming an epitaxial layer on the wafer W. The ports 211 of the first layer can be installed 0.5 to 1 mm above a surface of the wafer W. The gas injected into the chamber 110 through the ports 211 of the first layer may be adsorbed on the surface of the wafer W by heat of the wafer W. For example, the raw gas may be silicon or carbon when forming a silicon carbide epitaxial layer. This raw gas can be discharged from the ports 211 of the first layer together with a hydrogen gas, which is a carrier gas, and nitrogen and aluminum can also be discharged here.

The silicon raw gas may be any of the gases including silicon, such as silane (SiH₄), trichlorosilane (SiHCl₃), dichlorosilane (SiHCl₂), silicon tetrachloride (SiCl₄), and disilane (Si₂H₆). The raw carbon gas may be a hydrocarbon-based gas including carbon and hydrogen, such as acetylene (C₂H₂), ethylene (C₂H₄), methane (CH₄), ethanol (C₂H₅OH), methanol (CH₃OH), and propane (C₃H₈). As a material injected as an impurity, nitrogen can be used in a case of an N-type, and aluminum can be used in a case of a P-type. The impurity gas can be discharged from the ports 211 of the first layer simultaneously with the raw gas or with a slight time difference. In addition to the above gas, the ports 211 of the first layer can discharge gases necessary for a growth of silicon carbide (SiC), such as hydrochloric acid (HCl), nitrogen (N2), aluminum (Al), or argon (Ar).

The ports 212 of a second layer may be positioned above the ports 211 of the first layer. The ports 212 of the second layer may discharge a blocking gas blocking the raw gas from dispersing upward. The blocking gas may be the hydrogen gas, for example, in a growth process of the silicon carbide epitaxial layer. The hydrogen gas may form a hydrogen barrier film (or a hydrogen dome) on the wafer W. The gas discharged from the ports 211 of the first layer may be blocked by the hydrogen barrier film, and prevented from being diffused into an upper space of the chamber 110. The raw gas may act only on the wafer W due to this hydrogen barrier film, and gas concentration of the raw gas acting on the wafer W can thus be maintained high. Accordingly, a growth speed of the silicon carbide epitaxial layer can be 25 µm or more per minute. The ports 212 of the second layer can be installed 1.5 to 3 mm above the surface of the wafer W. In that case, the discharged hydrogen gas may effectively form the barrier film on the wafer W rather than being adsorbed on the surface of the wafer W.

The ports 213 of a third layer may be positioned below the ports 211 of the first layer. The ports 213 of the third layer may discharge a purifying gas purifying a by-product. The by-product may occur during a growth of the epitaxial layer. The purifying gas may be an argon gas. The purifying gas may be input at a point when the growth of the epitaxial layer is completed. The ports 213 of the third layer can be installed 0.2 to 0.4 mm above the surface of the wafer W.

The ports 213 of the third layer may discharge hydrogen and chlorhexidine (CHX, mainly propane (C₃H₈))-based hydrocarbon gas. A carbon (C)/silicon (Si) ratio may be a process variable necessary to be considered when growing SiC, such as a P-type SiC, an N-type SiC, or a semi-insulating SiC. When a ratio of silicon and hydrocarbon discharged from the ports 211 of the first layer is not suitable, the C/Si ratio can be adjusted by additionally discharging the carbon gas from the ports 213 of the third layer. The C/Si ratio may be necessary to range from 0.6 to 2.7 to grow the P-type SiC, the N-type SiC, or the semi-insulating SiC to suit an intended use. Here, hydrogen may serve to transport the carbon gas.

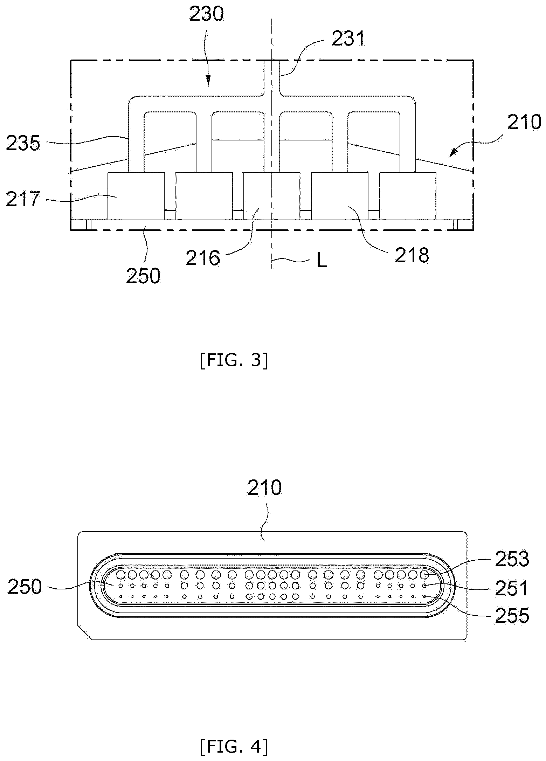

For the ports 211 of the first layer to the ports 213 of the third layer, the ports of each layer may be divided into ports 216, 217, and 218 corresponding to a region of the wafer W. This configuration is described with reference to FIG. 3.

The flow distribution unit 230 may distribute the gas flow input to the injector 210 for each port of the injector 210. The gas flows for the respective regions may be independent from each other. This configuration is also described in detail with reference to FIG. 3.

Referring back to FIGS. 1 and 2, the baffle 250 may include through holes 251, 253, and 255 through which the gas input through the injector 210 passes. Shapes of the through holes 251, 253, and 255 may be different for the ports 211, 212, and 213/216, 217, and 218 of the injector 210. This configuration is described in more detail with reference to FIGS. 4 to 7.

Referring back to FIGS. 1 and 2, the insert 270 may be disposed between the baffle 250 and the liner 290, and guide the gas passed through the baffle 250 to the liner 290. The insert 270 may also have a plurality of zones through which the gas passes.

The liner 290 may surround the susceptor 150, and guide the gas to flow into the wafer W. To this end, the liner 290 may have a generally ring shape. The liner 290 may have a part positioned on one side and discharging the gas toward the wafer W, and a part positioned on the other side and discharging the gas away from the wafer W.

The source module 300 may be a gas tank storing the gas to be supplied to the reaction chamber 110, or an intermediate distributor connected thereto.

Hereinafter, the injector 210 and the flow distribution unit 230 are described with reference to FIG. 3. FIG. 3 is a horizontal cross-sectional view showing a configuration related to the injector of FIG. 2.

Referring to this drawing further, the injector 210, in detail, the port 211, 212, or 213 of its individual layer may include a center port 216, an edge port 217, and a middle port 218.

The center port 216 may be positioned to correspond to a central region of the wafer W. The pair of edge ports 217 may be positioned to correspond to both edge regions of the wafer W. The middle port 218 can be disposed between the center port 216 and the edge port 217. The pair of middle ports 218 may also be positioned on both of left and right sides of the center port 216. Left and right portions of the center port 216, the pair of edge ports 217, and the pair of middle ports 218 may respectively be symmetric to each other based on an imaginary line L passing through a center of the center port 216. The center port 216, the edge port 217, and the middle port 218 may have the same width (or a length in a left-right direction in the drawing) or volume as one another. Furthermore, only the center port 216 and the pair of edge ports 217 may be provided without the middle port 218. In this case, regions of the center port 216 and the edge port 217 can be enlarged to cover those of the middle port 218.

The flow distribution unit 230 may have an inflow line 231 and a branch line 235. The inflow line 231 may be one (or single) line communicating with the source module 300 to receive the gas input. On the other hand, the branch line 235 may be branched off from the inflow line 231 and connected to each of the ports 211, 212, and 213/216, 217, and 218.

The flow distribution unit 230 may have a mass flow controller (not shown) connected to each of the ports 211, 212, and 213/216, 217, and 218. Each mass flow controller may be set to independently distribute the gas flow input to each of the ports 211, 212, and 213/216, 217, and 218. For example, the gas flow input to the center port 216 can be set to the lowest, and the gas flow input to the pair of edge ports 217 can be set to the highest. The gas flow input to the pair of middle ports 218 can be set to their intermediate level. The flow distribution unit 230 can also distribute the gas for the gas flow input to the pair of edge ports 217 or the pair of middle ports 218 to be symmetric to each other based on the center port 216.

Next, the description describes the baffle 250, which passes the gas discharged by divided into a plurality of regions through the injector 210 toward the reaction chamber 110, with reference to FIGS. 4 to 7.

First, FIG. 4 is a front view showing the baffle and injector of FIG. 2.

Referring to this drawing, the gas discharged from each of the ports 211, 212, and 213/216, 217, and 218 may pass through the through holes 251, 253, or 255 of the baffle 250.

The through holes 251, 253, and 255 may include the through holes 251 of a first layer, through holes 253 of a second layer, and the through holes 255 of a third layer. The through holes 251 of the first layer may be positioned to correspond to the ports 211 of the first layer. The through holes 253 of the second layer may be positioned to correspond to the ports 212 of the second layer, and the through holes 255 of the third layer may be positioned to correspond to the ports 213 of the third layer.

The through holes 253 of the second layer may have a uniform size, and be positioned to correspond to those of the center port 216, the middle port 218, and the edge port 217. On the other hand, the through holes 251 of the first layer and the through holes 255 of the third layer may have sizes gradually smaller from a size corresponding to that of the center port 216 to a size corresponding to that of the edge port 217. This configuration may be provided for a large amount of the blocking gas passing through the through holes 253 of the second layer to be injected into the chamber 110 regardless of the region, and the raw gas and the purifying gas respectively passing the through holes 251 of the first layer and the through holes 255 of the third layer to be injected to the respective regions of the wafer W at different speeds. In detail, a speed of the gas flow may be slower at an edge than a center of the wafer W, and it is thus possible to compensate for the speed of the gas flow passing through the holes by reducing the sizes of the through holes from their positions corresponding to those of the center port 216 to their positions corresponding to those of the edge port 217.

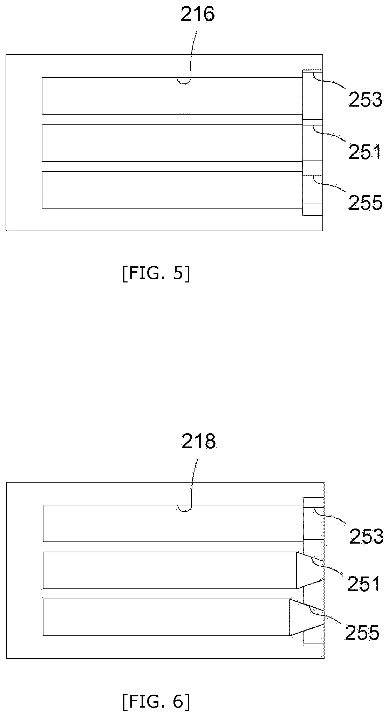

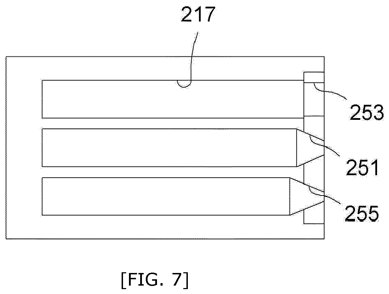

Next, FIG. 5 is a cross-sectional view showing shapes of the center ports and corresponding through holes of FIG. 4; FIG. 6 is a cross-sectional view showing shapes of the middle ports and corresponding through holes of FIG. 4; and FIG. 7 is a cross-sectional view showing shapes of the edge ports and corresponding through holes of FIG. 4

Referring to the drawings, for all the ports 211 of the first layer and the ports 213 of the third layer, the center port 216, the middle port 218, and the edge port 217 may have the uniform sizes. In addition, among the through holes 253 of the second layer, the through holes 253 corresponding to the center port 216, the middle port 218, and the edge port 217 may also have the same size as each other. This through hole 253 may have a cylindrical shape, thus having no change in a width (or diameter) from its input end to its output end.

The through holes 251 of the first layer and the through holes 255 of the third layer may have a mixture of the cylindrical shape and a cone shape. For example, each of the through holes 251 and 255 corresponding to the center port 216 may have the cylindrical shape, and each of the through holes 251 and 255 corresponding to the edge port 217 and the middle port 218 may have the cone shape.

Each of the through holes 251, 253, and 255 corresponding to the center port 216 may have a smaller width in a direction from the through holes 253 of the second layer through the through holes 251 of the first layer to the through holes 255 of the third layer. This relationship can be equally applied to the through holes 251, 253, and 255 corresponding to the middle port 218 between the through holes 251, 253, and 255 corresponding to the edge port 217. This relationship may cause the speed of the injected gas to be increased as the port has a height approaches that of the wafer W.

According to the epitaxial growth apparatus and the multi-layer gas supply module used therefor according to the present disclosure configured as described above, the multi-layer gas supply module supplying the gas to the wafer seated on the susceptor in the reaction chamber may independently distribute the gas flow to each port through the injector including the ports of the plurality of layers, each of which outputs the different gas for each layer, the ports of each layer including the center port and the pair of edge ports disposed on the left and right sides of the center port, to provide the uniform gas distribution in the entire region of the large-area substrate, thereby allowing the epitaxial layer to grow uniformly.

The epitaxial growth apparatus and the multi-layer gas supply module used therefor as described above are not limited to the configurations and operation methods of the embodiments described above. The embodiments described above may be variously modified by selective combinations of all or some of the respective embodiments.

## Claims

1. An epitaxial growth apparatus comprising:
a reaction chamber;
a susceptor positioned in the reaction chamber and configured to seat a wafer thereon; and
a multi-layer gas supply module configured to supply a gas to the reaction chamber to form an epitaxial layer on the wafer,
wherein the multi-layer gas supply module includes
an injector including ports of a plurality of layers, each of which discharges a different gas for each layer, among the ports of the plurality of layers, the ports of each layer including a center port corresponding to a central region of the wafer, a pair of edge ports corresponding to both edge regions of the wafer, and a pair of middle ports respectively disposed between the center port and the pair of edge ports,
a flow distribution unit configured to independently distribute the gas to the ports by including a single inflow line receiving the gas from a source module, a plurality of branch lines branched off from the single inflow line and directly connected to the respective ports, and a mass flow controller connected to each of the ports, and
a baffle including through holes which are positioned in front of the injector, and through which the gas discharged from the ports passes, among the through holes, the through holes corresponding to the ports of at least one layer among the ports of the plurality of layers having shapes different from each other.

2. The apparatus of claim 1, wherein the center port, the middle port, and the edge port have the same width as one another.

3. The apparatus of claim 1, wherein the ports of the plurality of layers include
ports of a first layer discharging a raw gas forming the epitaxial layer, and
ports of a second layer positioned above the ports of the first layer and discharging a blocking gas blocking the raw gas from diffusing upward.

4. The apparatus of claim 3, wherein the ports of the plurality of layers further include ports of the third layer disposed below the ports of the first layer and discharging a purifying gas purifying a by-product occurring during a growth of the epitaxial layer.

5. The apparatus of claim 4, wherein the through holes include the through holes of a first layer corresponding to the ports of the first layer, the through holes of a second layer corresponding to the ports of the second layer, and the through holes of a third layer corresponding to the ports of the third layer,
the through holes of the second layer have a cylindrical shape, and
the through holes of the first layer and the through holes of the third layer have a mixture of the cylindrical shape and a cone shape.

6. The apparatus of claim 5, wherein among the through holes of the first layer and the through holes of the third layer, the through holes corresponding to the center port have the cylindrical shape, and
among the through holes of the first layer and the through holes of the third layer, the through holes corresponding to the edge port have a cone shape.

7. The apparatus of claim 5, wherein the through holes of the third layer have cross-sectional areas each having a smaller size compared to those of the through holes of the first layer.

8. A multi-layer gas supply module used for an epitaxial growth apparatus, in which the module supplies a gas input to a reaction chamber of the epitaxial growth apparatus, the module comprising:
an injector including ports of a plurality of layers, each of which discharges a different gas for each layer, among the ports of the plurality of layers, the ports of each layer including a center port corresponding to a central region of the wafer, a pair of edge ports corresponding to both edge regions of the wafer, and a pair of middle ports respectively disposed between the center port and the pair of edge ports;
a flow distribution unit configured to independently distribute the gas to the ports by including a single inflow line receiving the gas from a source module configured to provide the gas, a plurality of branch lines branched off from the single inflow line and directly connected to the respective ports, and a mass flow controller connected to each of the ports; and
a baffle including through holes which are positioned in front of the injector, and through which the gas discharged from the ports passes, among the through holes, the through holes corresponding to the ports of at least one layer among the ports of the plurality of layers having shapes different from each other.

9. The module of claim 8, wherein the center port, the middle port, and the edge port have the same width as one another.

10. The module of claim 8, wherein the ports of the plurality of layers include
ports of a first layer discharging a raw gas forming the epitaxial layer, and
ports of a second layer positioned above the ports of the first layer and discharging a blocking gas blocking the raw gas from diffusing upward.

11. The module of claim 10, wherein the through holes include the through holes of a first layer corresponding to the ports of the first layer, the through holes of a second layer corresponding to the ports of the second layer, and the through holes of a third layer corresponding to the ports of the third layer,
the through holes of the second layer have a cylindrical shape, and
the through holes of the first layer have a mixture of the cylindrical shape and a cone shape.

12. An epitaxial growth apparatus comprising:
a reaction chamber;
a susceptor positioned in the reaction chamber and configured to seat a wafer thereon; and
a multi-layer gas supply module configured to supply a gas to the reaction chamber to form an epitaxial layer on the wafer,
wherein the multi-layer gas supply module includes
an injector including ports of a plurality of layers, each of which discharges a different gas for each layer, among the ports of the plurality of layers, the ports of each layer including a center port corresponding to a central region of the wafer, and a pair of edge ports corresponding to both edge regions of the wafer, and
a flow distribution unit configured to distribute gas flows input to the center port and the edge port among the ports of each layer independently from each other.

13. The apparatus of claim 12, wherein among the ports of the plurality of layers, the ports of each layer further include a pair of middle ports respectively disposed between the center port and the pair of edge ports, and
the flow distribution unit is configured to distribute the gas flow input to the middle port independently from the gas flow input to the center port or the edge port.
